Europäisches Patentamt

European Patent Office

Office européen des brevets

(11) Numéro de publication: **0 027 395**
A1

# DEMANDE DE BREVET EUROPEEN

(21) Numéro de dépôt: **80401334.0**

(22) Date de dépôt: **19.09.80**

(51) Int. Cl.³: **H 01 L 21/56**
H 01 L 23/28, H 01 L 21/205
H 01 L 21/314

(30) Priorité: **05.10.79 FR 7924888**

(43) Date de publication de la demande:
**22.04.81 Bulletin 81/16**

(84) Etats Contractants Désignés:
**DE GB IT NL**

(71) Demandeur: **THOMSON-CSF**
**173, Boulevard Haussmann**
**F-75360 Paris Cedex 08(FR)**

(72) Inventeur: **Duchemin, Jean-Pascal**
**"THOMSON-CSF" SCPI 173, Bld Haussmann**
**F-75360 Paris Cedex 08(FR)**

(72) Inventeur: **Henry, Raymond**
**"THOMSON-CSF" SCPI 173, Bld Haussmann**
**F-75360 Paris Cedex 08(FR)**

(72) Inventeur: **de Cremoux, Baudouin**
**"THOMSON-CSF" SCPI 173, Bld Haussmann**
**F-75360 Paris Cedex 08(FR)**

(72) Inventeur: **Bonnet, Michel**
**"THOMSON-CSF" SCPI 173, Bld Haussmann**
**F-75360 Paris Cedex 08(FR)**

(74) Mandataire: **Giraud, Pierre et al,**
**"THOMSON-CSF" - SCPI 173, bld Haussmann**
**F-75360 Paris Cedex 08(FR)**

(54) **Procédé de passivation de composants semiconducteurs à l'arséniure de gallium.**

(57) L'invention a pour but la passivation d'un composant électronique du type à matériau semiconducteur, dans le cas de Ga As, par une couche semi-isolante (4) présentant sensiblement le même coefficient de dilatation thermique que Ga As.

A cet effet, le substrat monocristallin de Ga As est soumis à deux épitaxies successives, par exemple en phase vapeur dans le même appareil, au cours desquelles on fait agir successivement les composés habituels de la formation, épitaxique de Ga As, pour constituer une couche active (3) avec un dopant approprié, puis des composés gazeux susceptibles, avec un dopant convenable, de former $Ga_xA\ell_{1-x}As$ avec x compris entre 0 et 1, ou bien $Ga_{0,47}In_{0,53}P$ semi-isolants de même taille de réseau cristallin que Ga As pour constituer la couche (4).

Application aux diodes et aux transistors.

FIG. 4

Croydon Printing Company Ltd.

1

## PROCEDE DE PASSIVATION DE COMPOSANTS
## SEMICONDUCTEURS A L'ARSENIURE DE GALLIUM

L'invention concerne un procédé de passivation de composants semiconducteurs à l'arséniure de gallium.

On sait que la fiabilité des composants électroniques à semiconducteurs est améliorée par l'existence d'une protection du matériau semiconducteur actif par une couche isolante dite de passivation.

On sait aussi que, notamment lorsque le semiconducteur est de l'arséniure de gallium, il est utile que :

- d'une part, le matériau de passivation soit plutôt "semi-isolant" que parfaitement isolant, car il est alors suffisamment conducteur de l'électricité pour faciliter l'évacuation des charges électriques existant dans les pièges de l'interface situé entre semiconducteur et couche passivante ;

- d'autre part, les coefficients de dilatation thermique de l'un et de l'autre soient aussi proches que possible, ce qui exclut la silice et les verres au silicate dans le cas de l'arséniure de gallium.

On a proposé de constituer la couche de protection par de l'arséniure de gallium monocristallin semi-isolant, que l'on fait croître par épitaxie dans les intervalles séparant les électrodes du composant semiconducteur.

Toutefois l'arséniure de gallium semi-isolant présente un inconvénient lorsque on désire, dans le cadre de la technologie habituelle, faire d'abord croître la couche de protection sur toute la surface de la couche active, par épitaxie, puis ouvrir, par attaque chimique, des fenêtres d'accès à la couche active correspondant aux différentes électrodes du composant. En effet, dans un tel cas, il devient difficile, lorsque le matériau de passivation est identique au semiconducteur, d'arrêter avec précision l'attaque chimique pour simplement mettre à nu la couche active sans entamer celle-ci ce qui présente à priori des inconvénients.

L'invention permet de remédier à cette difficulté, tout en satisfaisant aux exigences précédemment énoncées pour le cas de l'arséniure de gallium.

Le procédé de passivation suivant l'invention est principalement caractérisé en ce qu'il comporte une étape de fabrication du composant à l'arséniure de gallium au cours de laquelle on fait croître par épitaxie à partir d'une couche monocristalline d'arséniure de gallium, successivement, en une première sous-étape, la couche active d'arséniure de gallium dopée de façon prédéterminée, puis, en une deuxième sous-étape, une couche de passivation constituée par un monocristal, dopé de manière à être électriquement semi-isolant, ayant une composition qui réponde à l'une des formules suivantes :

$$Ga_x \, Al_{1-x} As$$

dans laquelle x est compris entre 0 et 1,

et $Ga_y \, In_{1-y} \, P$ où $0,46 \leqslant y \leqslant 0,48$

L'invention sera mieux comprise et d'autres caractéristiques apparaîtront, au moyen de la description qui suit, et des dessins qui l'accompagnent, parmi lesquels :

Les figures 1 à 3 représentent, en coupes schématiques, trois stades successifs de réalisation d'un composant suivant l'invention ;

La figure 4 est une coupe d'un exemple de transis-

3

tor à effet de champ fabriqué suivant l'invention ;

La figure 5 est une coupe de diode Schottky fabriquée suivant l'invention.

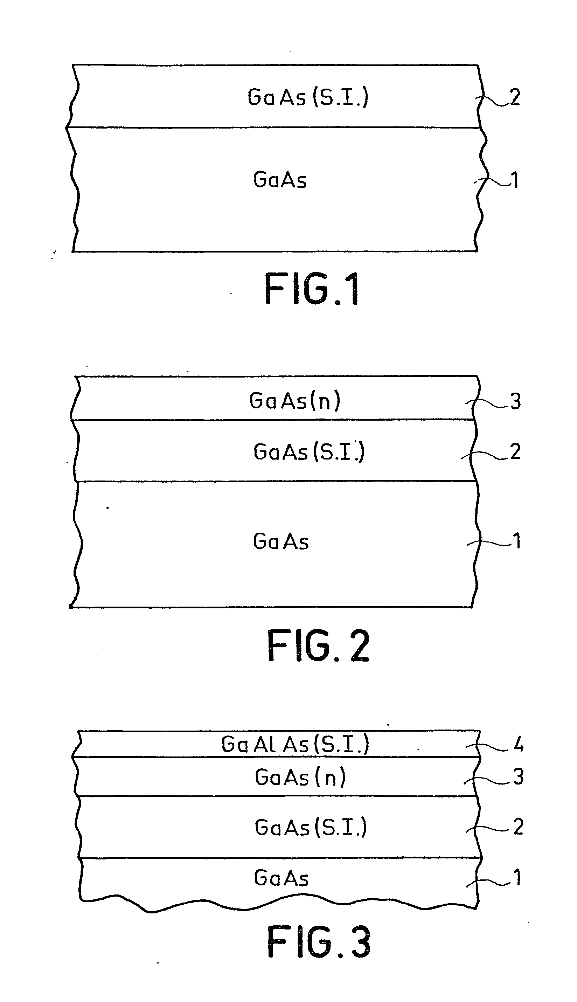

Dans l'exemple de mise en oeuvre du procédé, représenté figures 1 à 3, on part d'un substrat 1 (figure 1) en arséniure de gallium, revêtu d'une couche 2 d'arséniure de gallium monocristallin semi-isolant.

Le substrat est traité par épitaxie dans un appareil de traitement, par exemple, en phase vapeur, dans lequel on injecte des composés organométalliques sous forme gazeuse, de l'hydrogène et des dopants qui diffèrent suivant le résultat à obtenir.

Dans une première sous-étape, destinée à obtenir la couche active du composant en arséniure de gallium, par exemple de type n, les composants organo-métalliques sont, en qualité et en quantité, ceux qui permettent d'obtenir un composé de formule GaAs, soit par exemple des vapeurs de $Ga(CH_3)_3$ et $AsH_3$.

Le dopant utilisé est un composé d'une impureté, par exemple de type n, sous la forme d'un hydrure, par exemple $SiH_4$ en phase vapeur. On obtient ainsi une couche active 3 (figure 2) de GaAs, au cours d'une première sous-étape d'épitaxie.

Dans une deuxième sous-étape d'épitaxie, les composés organo-métalliques sont en qualité et en quantité des gaz ou vapeurs permettant d'obtenir par leur décomposition dans l'appareil d'épitaxie une croissance d'une couche de $Ga_xAl_{1-x}As$ avec x compris par exemple entre 0,1 et 0,2. Il s'agit par exemple de $Ga(CH_3)_3$, de $Al(CH_3)_3$ et d'$AsH_3$. On injecte en outre de l'oxygène pendant l'épitaxie dans la proportion d'un millionième pour obtenir une couche semi-isolante 4 (figure 3) destinée à jouer le rôle de matériau de passivation.

Dans une variante du procédé selon l'invention, la couche de passivation est réalisée en faisant croître,

4

sur le monocristal de GaAs, une couche monocristalline d'un composé ternaire ayant le même paramètre de réseau cristallin, à savoir $Ga_{0,47}In_{0,53}P$. Les gaz introduits dans l'appareil d'épitaxie au cours de la deuxième sous-étape d'épitaxie sont alors, outre l'hydrogène, des vapeurs de $Ga(CH_3)_3$, $In(C_2H_5)_3$ et $PH_3$ et un dopant tel que le chrome contenu dans des vapeurs de $Cr(CO)_6$.

Dans l'exemple précédemment décrit, le dopage peut être effectué par d'autres méthodes classiques en phase vapeur, telles que le transport de fer par $ClH$ ou du chrome dans la variante ci-avant.

Dans d'autres variantes de l'invention, on utilise d'autres méthodes classiques d'épitaxie : transport d'éléments en phase gazeuse, jets moléculaires, ou même épitaxie en phase liquide. Toutefois, dans ce dernier cas, les sous-étapes sont plus nettement séparées, le substrat étant alors retiré d'un premier bain d'épitaxie pour être plongé dans un deuxième bain de composition différente.

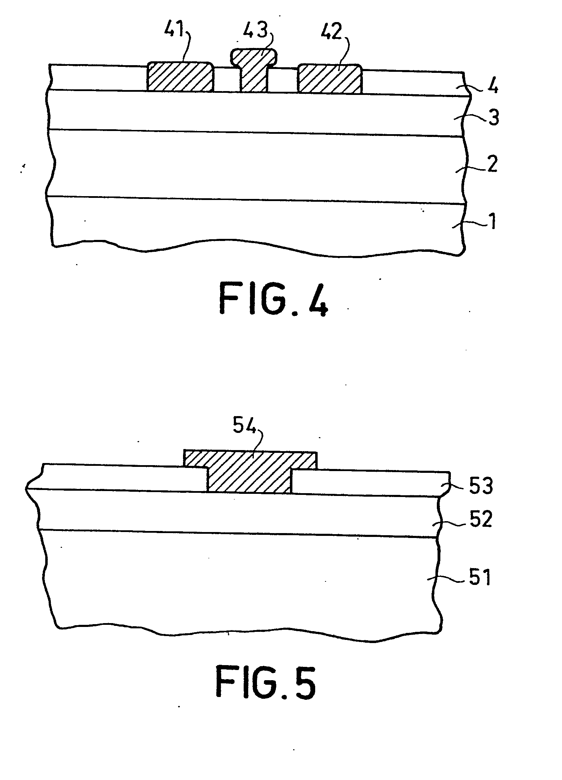

Figure 4, on a représenté, à titre d'exemple, un composant électronique réalisé par le procédé selon l'invention, à savoir une structure de transistor à effet de champ utilisant comme couche active la couche 3 du corps semiconducteur représenté figure 3, et comme couche de passivation la couche 4 du même corps, représentée ici après des étapes de fabrication comportant :

- l'ouverture de fenêtres dans la couche 4, par photolithographie ;

- le dépôt d'un ou plusieurs métaux pour constituer des contacts ohmiques 41 et 42 destinés à être utilisés comme source et drain du transistor à effet de champ ;

- le dépôt d'un métal pour former un contact 43 de type Schottky, destiné à être utilisé comme grille du transistor.

On n'a pas représenté la finition proprement dite

0027395

5

du composant électronique, comportant notamment le raccordement de connexions électriques aux électrodes du transistor à effet de champ.

Figure 5, on a représenté en coupe schématique une structure de diode Schottky fabriquée suivant l'invention. Sur un substrat 51 en GaAs dopé $n^+$, on a fait croître une couche 52 de GaAs dopé n puis une couche 53 d'un composé ternaire, par exemple $Ga_xAl_{1-x}As$, et on a formé un contact Schottky à l'aide d'un dépôt 54 de métal dans une fenêtre préalablement ouverte dans la couche 53.

Parmi les avantages de l'invention on doit encore signaler le fait que l'interface entre l'arséniure de gallium monocristallin et une couche épitaxiale d'un composé ternaire tel que $Ga_xAl_{1-x}As$ ne présente pas de pièges capables de retenir des charges parasites, ce qui permet d'obtenir des composants électroniques fonctionnant aux fréquences élevées sans présenter de bruit dit en "1/f" ou bruit de scintillation trop important.

L'invention peut être mise en oeuvre en utilisant, pour constituer la couche de passivation, d'autres composés ternaires d'éléments appartenant aux colonnes 3 et 5 de la classification de Mendéléev, à condition que la maille du réseau cristallin soit assez proche de celle de GaAs pour permettre une croissance épitaxiale et que le coefficient de dilatation thermique soit relativement proche de celui de l'arséniure de gallium pour éviter des fêlures en cas de brusque variation de température.

6

## REVENDICATIONS

1. Procédé de passivation d'un composant électronique à semiconducteur, comportant une couche active d'arséniure de gallium, caractérisé en ce qu'il comporte une étape de fabrication du composant au cours de laquelle on fait croître par épitaxie à partir d'une couche monocristalline d'arséniure de gallium, successivement en une première sous-étape la couche active d'arséniure de gallium dopée de façon prédéterminée, puis, en une deuxième sous-étape, une couche de passivation constituée par un monocristal, dopé de manière à être électriquement semi-isolant, ayant une composition qui réponde à l'une des formules suivantes :

$$Ga_x \, Al_{1-x} As$$

dans laquelle x est compris entre 0 et 1,

et $Ga_y In_{1-y}$ P dans laquelle $0,46 \leq y \leq 0,48$

2. Procédé suivant la revendication 1, caractérisé en ce que, pour constituer une couche de passivation en arséniure de gallium et d'aluminium, on effectue les opérations d'épitaxie des deux sous-étapes en phase vapeur, la composition de cette phase comportant des composés gazeux d'arsenic et de gallium dans la première sous-étape et des composés gazeux d'arsenic, de gallium et d'aluminium dans la deuxième sous-étape.

3. Procédé suivant la revendication 2, caractérisé en ce que les composés gazeux d'arsenic, de gallium et d'aluminium sont respectivement $As \, H_3$, $Ga \, (C \, H_3)_3$ et $Al \, (C \, H_3)_3$, dans un courant d'hydrogène, un premier dopant introduit pendant la première sous-étape étant une impureté de type n sous forme gazeuse, et un deuxième dopant, introduit pendant la deuxième sous-étape étant $Cr \, (C \, O)_6$.

4. Procédé suivant la revendication 1, caractérisé en ce que, pour constituer une couche de passivation en

7

phosphure d'indium et de gallium, on effectue les opérations d'épitaxie des sous-étapes en phase vapeur, celle-ci comportant des composés d'arsenic et de gallium pendant la première sous-étape, et des composés de phosphore, d'indium et de gallium pendant la deuxième sous-étape.

5. Procédé suivant la revendication 4, caractérisé en ce que les composés utilisés dans la première sous-étape sont $As\ H_3$ et $Ga\ (C\ H_3)_3$ et dans la deuxième sous-étape $P\ H_3$, $In\ (C_2H_5)_3$ et $Ga\ (C\ H_3)_3$.

6. Procédé suivant la revendication 5, caractérisé en ce que, pendant la deuxième sous-étape, la phase gazeuse comporte en outre $Cr\ (C\ O)_6$.

7. Procédé suivant l'une quelconque des revendications 1 à 6, caractérisé en ce que, pour l'obtention d'un transistor à effet de champ comportant une couche de passivation, ce procédé est complété par les étapes suivantes :

- ouverture de fenêtres dans la couche de passivation ;

- formation de contacts ohmiques dans les fenêtres de source et de drain ;

- formation de contact Schottky par dépôt de métal dans la fenêtre de grille.

8. Procédé suivant l'une quelconque des revendications 1 à 6, caractérisé en ce que, pour l'obtention d'une diode comportant une couche de passivation, ce procédé est complété par les étapes suivantes :

- ouverture d'une fenêtre dans la couche de passivation ;

- dépôt d'un métal dans la fenêtre ainsi ouverte.

GaAs (S.I.) ～ 2

GaAs ～ 1

## FIG.1

GaAs(n) ～ 3

GaAs (S.I.) ～ 2

GaAs ～ 1

## FIG. 2

GaAl As (S.I.) ～ 4

GaAs (n) ～ 3

GaAs (S.I.) ～ 2

GaAs ～ 1

## FIG.3

FIG. 4

FIG. 5

**0027395**

<table>
<tr><td rowspan="2">
<strong>Office européen<br>des brevets</strong>

## RAPPORT DE RECHERCHE EUROPEENNE
</td><td>Numéro de la demande<br><br>EP 80 40 1334</td></tr>
</table>

| | DOCUMENTS CONSIDERES COMME PERTINENTS | | CLASSEMENT DE LA DEMANDE (Int. Cl. 3) |
|---|---|---|---|
| **Catégorie** | Citation du document avec indication, en cas de besoin, des parties pertinentes | Revendica-tion concernée | |
| | FR - A - 2 162 195 (WESTERN ELEC-TRIC)<br><br> * Revendications 1,5 *<br><br>-- | 1 | H 01 L 21/56<br>23/28<br>21/205<br>21/314 |
| | FR - A - 2 365 882 (THOMSON-CSF)<br><br> * Revendications 1,4,6,11,12 *<br><br>-- | 1,2,8 | |
| | FR - A - 2 390 017 (MITSUBISHI MONSANTO)<br><br> * Revendications 1,23,24,27; page 1, lignes 16-24; page 5, ligne 32 - page 6, ligne 27; page 16, lignes 17-23 *<br><br>-- | 1-3,5, 8 | **DOMAINES TECHNIQUES RECHERCHES (Int. Cl. 3)**<br><br>H 01 L 21/56<br>23/28<br>21/205<br>21/314 |
| | APPLIED PHYSICS LETTERS, vol. 35, no. 3, août 1979<br>New York US<br>T.J. MAGEE et al.: "Back surface gettering and Cr out-diffusion in VPE GaAs layers", pages 277-279<br><br> * Page 277, colonne de gauche *<br><br>-- | 1-3,7 | |
| | JOURNAL OF THE ELECTROCHEMICAL SOCIETY, vol. 126, no. 7, juillet 1979,<br>Princeton US<br>J.P. DUCHEMIN et al.: "A new method for growing GaAs epilayers by low pressure organometallics" pages 1134-1142<br><br> * Page 1134, colonne de droite, alinéa 3; page 1141, colonne de gauche *<br><br>-- ./. | 1-3,5, 7,8 | **CATEGORIE DES DOCUMENTS CITES**<br><br>X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cité pour d'autres raisons<br><br>&: membre de la même famille, document correspondant |

Le présent rapport de recherche a été établi pour toutes les revendications

| Lieu de la recherche | Date d'achèvement de la recherche | Examinateur |
|---|---|---|
| La Haye | 16-01-1981 | DE RAEVE |

OEB Form 1503.1 06.78

| DOCUMENTS CONSIDERES COMME PERTINENTS | | | CLASSEMENT DE LA DEMANDE (Int. Cl. ³) |
|---|---|---|---|
| Catégorie | Citation du document avec indication, en cas de besoin, des parties pertinentes | Revendication concernée | |
| | FR - A - 2 021 226 (SIEMENS)<br>* Revendications 1,5 *<br><br>-- | 1-3,5 | |
| | IBM TECHNICAL DISCLOSURE BULLETIN vol. 14, no. 3, août 1971, New York US<br>A.E. BLAKESLEE: "Forming thin-insulating crystal layers", page 814<br>* Alinéa 1 *<br><br>---- | 1-3,5 | |
| | | | **DOMAINES TECHNIQUES RECHERCHES (Int. Cl. ³)** |

OEB Form 1503.2   06.78